# EUROPEAN PATENT APPLICATION

(11) **EP 3 917 293 A1**
(43) Date of publication of application: **01.12.2021**
(21) Application number: 20176565.8
(22) Date of filing: 26.05.2020
(51) Int. Cl.: H05K 1/18, H05K 3/32, H05K 3/34, H05K 13/04, H05K 3/12

(54) **TOPOGRAPHY-BASED DEPOSITION HEIGHT ADJUSTMENT**

(71) Applicant: MYCRONIC AB, 183 03 Täby (SE)
(72) Inventor: Mårtensson, Gustaf, 170 74 SOLNA (SE); Gustafsson, Per-Erik, 169 54 Solna (SE)
(74) Representative: AWA Sweden AB

(57) **Abstract**

A method for mounting a component (100) on a workpiece (106), the method comprising obtaining information regarding a surface topography of at least one of a first surface (102) of the component and a local surface (108) of the workpiece onto which the component is to be mounted. The method further comprises identifying, from the information, at least one portion (112) of the first or local surface at which a distance (d) between the component and the workpiece, upon mounting of the component on the workpiece, will be larger than an average distance (dₐ) between the surfaces. The method further comprises forming a plurality of deposits (110) of a viscous medium on at least one of the first and local surfaces, wherein at least one deposit (110a) formed in the at least one portion has a height (h₁) which is larger than an average height (hₐ) of the plurality of deposits, and bringing the first and local surfaces together, such that the plurality of deposits of viscous medium ensures contact between the component and the workpiece.

## Description

### Technical field

The present disclosure relates generally to the field of mounting technology. More specifically it relates to a method for mounting a component onto a workpiece, and a system for depositing a viscous medium on a workpiece and/or a component.

### Background

In many fields of technology, such as the production of integrated circuits, components are mounted on, and connected to, workpieces using some form of viscous medium like adhesives, solder paste etc.

Components and workpieces are not always perfectly flat. During production, components and/or workpieces may become slightly bent or warped. Especially in fields in which components and/or workpieces become increasingly thinner, such as e.g. printed circuit board assembly (PCBA), the prevalence of warpage of components and workpieces may increase. These topographical features of components and workpieces may be further accentuated by treatment of the assembly comprising the component and the workpiece during or after mounting. As an example, application of energy, such as heat or light, with the purpose of melting or hardening the viscous medium, may increase warpage of the component and/or the workpiece.

Warpage may lead to a mismatch between the surfaces of the component and the workpiece. If the surfaces are not parallel, gaps may occur between the surfaces or between a surface and the viscous medium supposed to bind the surfaces together. Such gaps may decrease the stability of the mounting of the component, which may for example increase the risk of the component peeling off.

### Summary

It is therefore an object of the present invention to overcome at least some of the above-mentioned drawbacks, and to provide an improved method for mounting a component on a workpiece and an improved system for depositing a viscous medium on a component and/or on a workpiece.

This and other objects are achieved by means of a method and a system as defined in the appended independent claims. Other embodiments are defined by the dependent claims.

According to a first aspect of the present disclosure, a method for mounting a component on a workpiece is provided. The method comprises obtaining information regarding a surface topography of at least one of a first surface of the component and a local surface of the workpiece onto which the component is to be mounted.

The method further comprises identifying, from the obtained surface topography information, at least one portion of the first surface or the local surface at which a distance between the first surface and the local surface, upon mounting of the component on the workpiece, will be larger than an average distance between the first surface and the local surface.

Further, the method comprises forming a plurality of deposits of a viscous medium on at least one of the first surface and the local surface, such that at least one deposit formed in the at least one identified first portion has a height which is larger than an average height of the deposits within the plurality of deposits.

The method further comprises bringing the first surface and the local surface together, such that the plurality of deposits of viscous medium ensures contact between the component and the workpiece.

The local surface may be a portion of a mounting surface of the workpiece. A mounting surface of the workpiece may comprise one or more local surfaces, wherein each local surface may be adapted to receive a component.

The information regarding surface topography may comprise information about the shape of the first surface of the component and/or of the local surface of the workpiece. For example, it may comprise information about a deviation of the surface from a flat plane, such as a warpage or curvature of the first surface or the local surface.

From (or based on) this information, the average distance between the first surface and the local surface when the component is mounted on the workpiece may be calculated or estimated. A first portion (or a plurality of first portions) in which the distance between the first surface and the local surface will be larger than the average distance may further be identified.

Obtaining and analyzing information regarding a surface topography of at least one of the first surface and the local surface may for example be performed by (or by the use of) a computing device, such as a processor, a control unit or a computer.

Forming deposits may for example be performed by (or by the use of) a depositing device for depositing a viscous medium. A depositing device performing the formation of deposits in the method of the first aspect of this disclosure, may be in communicative contact with a computing device such as a processor, control unit or computer in which the obtaining information regarding surface topography and identifying portions in which the distance is larger than an average distance is performed. Such a computing device may also be integrated in the depositing device.

Bringing the first surface and the local surface together may for example be performed by (or by the use of) a mounting machine, a pick-and-place machine, a die bonder, or a mounting robot.

Differences in the topography of the first surface and/or the local surface, due to e.g. warpage of the component or workpiece, may lead to a non-constant distance between the surfaces when mounting the component on the workpiece. In places (portions) in which the distance is larger, it may be necessary to apply more viscous medium to ensure that the viscous medium is in contact with both surfaces when the component is mounted. Forming larger (higher) deposits in portions in which the distance between the first surface of the component and the local surface of the workpiece is larger than an average distance between the surfaces may ensure connection between the component and the workpiece. Thus, the component may be more securely mounted.

It will be appreciated that in a situation wherein, for example, the distance between the first surface and the local surface is substantially the same apart from in one portion in which the distance is shorter, the average distance between the surfaces will be (slightly) lower than the median distance (which will be equal to the substantially same distance between the remainder of the surfaces). Forming a relatively smaller deposit in the one portion in which the distance is shorter will then result in the deposits in the other regions having a height which is (slightly) larger than the average height.

The workpiece may for example comprise a board, such as a printed circuit board (PCB), a flexible PCB or a printed wiring board (PWB). Alternatively, the workpiece may be a substrate for ball grid arrays (BGA), a flexible substrate (e.g. paper or plastic), chip scale packages (CSP), quad flat packages (QFP), wafers, flip-chips, or the like. In some applications, the workpiece may be a material or surface which may receive viscous medium. The workpiece may be a flat surface or warped surface, but it is also envisioned that the substrate may form a three-dimensional surface and/or comprise irregular shapes and/or wells wherein the viscous medium is to be deposited.

The term 'deposit' may, in the context of the present disclosure, refer to the viscous material deposited onto the workpiece, for example in the form of a droplet or a dot.

The height of a deposit may be related to the volume of the deposit. A higher deposit may thus be formed by increasing the volume of the deposit. The term 'size' in relation to a deposit as discussed in the present disclosure may refer to the area on the workpiece or component that the deposit covers, e.g. defined by its diameter or footprint. An increase in the deposit volume may generally result in an increase in the deposit height as well as the deposit size.

In the present disclosure, the phrase 'based on' in the context of determining the distances or heights (or control parameters controlling the heights) may comprise 'determined as a function of', 'proportional', 'directly proportional', and 'derived from'.

According to some embodiments, obtaining information regarding a surface topography of at least one of the first surface of the component and the local surface of the workpiece may comprise performing surface measurements of at least one of the first surface and the local surface.

For example, the local surface of the workpiece may be scanned or otherwise measured. As another example, the entire mounting surface of the workpiece (comprising one or more local surfaces) may be scanned or otherwise measured. The first surface of the component may be scanned otherwise measured. Different methods and devices for scanning and measuring surfaces are known in the art.

According to some embodiments, obtaining information regarding a surface topography of at least one of the first surface of the component and the local surface of the workpiece may comprise retrieving information of a surface topography of at least one of the first surface and the local surface from a storage unit.

Many manufacturers provide detailed topography data of the components they produce. The storage unit may for example comprise topography data provided by the component manufacturer. Alternatively, or additionally, the storage unit may comprise data from previous measurements made on the component and/or the workpiece.

The storage unit may for example be a server, a non-volatile storage medium, an internal memory etc.

According to some embodiments, the method may further comprise identifying, from the information, at least one second portion of the first surface or the local surface at which a distance between the first surface and the local surface, upon mounting of the component on the workpiece, will be smaller than the average distance between the first surface and the local surface. At least one deposit formed in the at least one second portion may have a height which is smaller than the average height of the plurality of deposits.

Some components and/or workpieces, especially ones having larger surface areas, may have a more pronounced warpage or several regions in which the surface topography differs from a plane. Identifying both first portions with larger distances and second portions with smaller distances may provide that larger deviations in the distance may be compensated by altering the deposit heights.

A smaller (less high) deposit may e.g. be formed by forming a deposit with a smaller volume. Alternatively, a deposit of average height may be formed, and then some of the viscous material of the deposit removed, e.g. by suction.

According to some embodiments, the method may further comprise, for a plurality of positions at which deposits are to be formed, analyzing a distance between the first surface and the local surface upon mounting of the component on the workpiece based on the information regarding a surface topography. The method may further comprise, for each deposit which is to be formed in one of said plurality of positions, calculating a compensation factor based on the analysis of the distance. Forming a plurality of deposits may further comprise adapting a height of each deposit being formed in one of said plurality of positions based on its compensation factor.

The compensation factor may determine a quantity or factor by which the deposit volume or height is to differ from the average volume/height of the plurality of deposits. Alternatively, the compensation factor may determine a quantity or factor by which the deposit volume or height is to differ from a standard or nominal deposition volume or height.

The compensation factor for each deposit may be determined to compensate for differences in the distance between the first surface and the local surface at the position of each deposit.

It is appreciated that the step of analyzing a distance between the first surface and the second surface may comprise identifying at least a first portion in which the distance is larger than an average distance between the surfaces and/or at least a second portion in which the distance is smaller than an average distance between the surfaces.

According to some embodiments, forming a plurality of deposits may comprise forming said plurality of deposits and applying further viscous medium to at least one of said plurality of deposits, thereby forming at least one deposit having a height which is larger than an average height of the plurality of deposits.

For example, first, a plurality of deposits all having substantially the same height may be formed. Then, additional viscous medium may be added to deposits for which a larger height is required.

Given enough time, a quantity of viscous material on a surface, such as a deposit, may deform to optimize its surface energy. This effect may lead to a flattening and spreading out of droplets of viscous media on a surface. A larger volume deposit may lead to a larger footprint or size if the deposit spreads out. However, when working in shorter time-spans, it may be possible to form two or more deposits on top of one another, without the deposits spreading out/flattening.

Forming so called 'double-deposits', i.e. depositing additional material on an already formed deposit, may increase the height of a deposit without increasing the size/width/foot print as much as when forming a single deposit with a larger volume. Thus, the risk for (e.g. solder) bridging between two deposits may be decreased.

In embodiments in which a plurality of deposits is formed and height adaptations made afterwards, a smaller (less high) deposit may be formed by removing (e.g. by suction) a deposit and forming a smaller deposit (with a smaller volume) in the same place. Alternatively, the height of a deposit may be decreased by removing some of the material of the deposit.

According to some embodiments, the method may further comprise, after bringing the first surface and the local surface together, applying energy to the deposits, component, and/or the workpiece, to process the deposits. The information regarding a surface topography may comprise information regarding a predicted change in topography of at least one of the first surface and the local surface resulting from the application of energy.

Processing the deposits by application of energy to the deposits, component, and/or the workpiece may alter one or more properties of the viscous medium. Depending on the material, the viscosity of the viscous medium may for example decrease (melt, reflow) or increase (harden) as a reaction to the applied energy, which may in turn lead to more robust joints between the component and the workpiece.

For example, the method may comprise a reflow step, in which the workpiece and the component are subjected to energy in the form of controlled heat. This may (partially) melt the deposits, which may harden upon cooling to form permanent joints.

Exposure to heat may induce further changes in the topography of the workpiece and/or the component. These changes in topography often follow similar patterns, such that the resulting topography change can, at least approximately, be predicted. The predictions may for example be based on prior knowledge, testing, measurements, information from a producer etc. Using these predictions as part of the obtained topography information, based on which heights of one or more deposits may be determined, may allow for adapting deposit sizes to compensate these changes.

For example, the application of energy may include application of radiation, such as light, to the deposits. Treating/processing the deposits using radiation may cure/harden the deposits.

Application of energy may be selective to the deposits, e.g. by using a laser or other form focused energy transmitter aimed directly at the deposits. In such embodiments, energy such as heat may spread from the deposits to the workpiece and/or component to induce further warpage. Alternatively, application of energy may be broader, and e.g. aimed at the component or the workpiece, or to the assembly formed by the component mounted on the workpiece.

Many different types of components may be mounted onto different types of workpieces using methods described herein. The method may specifically apply to components having more than one point of contact to be connected with the workpiece.

According to some embodiments, the component may be an electrical component.

The component may be any electrical component having more than one connection point. The component may for example be a multiple input/output (I/O) electrical package.

According to some embodiment, the viscous medium may comprise an electrically conductive material.

Especially in embodiments wherein the component is an electrical component, a viscous medium comprising an electrically conductive material may ensure not only an adhesive or physical connection between the component and the workpiece, but also an electrical connection. Thus, in such embodiments, at least some deposits may act as electrical conductors allowing electrical signals to pass between the component and the workpiece.

For example, the viscous medium may comprise solder paste, electrically conductive glue or another electrically conductive material.

According to some embodiments, the component may comprise receptors and/or transmitters for optical signals and the workpiece may comprise corresponding receptors and/or transmitters for optical signals adapted for communication with the component. In such embodiments, the deposits of viscous material may, when the component is mounted on the workpiece, form communication channels, such as waveguides, allowing for optical signals to pass between the component and the workpiece.

The method in accordance with the first aspect of the present disclosure may further be used when a second component is to be mounted on the workpiece. The surface topography of the second component may be different from that of the (first) component. Further, the surface topography of the second local surface may be different from that of the (first) local surface.

The method may thus further comprise obtaining further information regarding a surface topography of at least one of a first surface of the second component, and a second local surface of the workpiece onto which the second component is to be mounted.

The method may further comprise identifying, from said further information, at least one further first portion of the first surface of the second component or the second local surface at which a distance between the first surface of the second component and the second local surface, upon mounting of the second component on the workpiece, will be larger than an average distance between the first surface of the second component and the second local surface.

The method may further comprise forming a second plurality of deposits of a viscous medium on at least one of the first surface of the second component and the second local surface, wherein at least one deposit formed in said at least one further first portion has a height which is larger than an average height of said second plurality of deposits, and bringing the first surface of the second component and the second local surface together, such that the second plurality of deposits of viscous medium ensures contact between the second component and the workpiece.

According to a second aspect of the present disclosure, a system for depositing a viscous medium is provided. The (depositing) device system comprises a depositing device which is arranged for depositing a viscous medium onto a first surface of a component to be mounted on a workpiece and/or a local surface of the workpiece onto which the component is to be mounted.

The system further comprises a control unit, which is adapted to obtain information regarding a surface topography of at least one of the first surface and the local surface of the workpiece.

The control unit is further adapted/configured to identify, from the obtained information, at least one first portion of the first surface of the local surface at which a distance between the first surface and the local surface, upon mounting of the component on the workpiece, will be larger than an average distance between the first surface and the local surface.

The control unit is further adapted/configured to determine, from the identification, heights of a plurality of deposits of a viscous medium that is to be deposited on at least one of the first surface and the local surface, such that at least one deposit formed in the at least one identified first portion has a height which is larger than an average height of the plurality of deposits.

The control unit may be an integrated part of the depositing device. The control unit may be external to the depositing device and arranged to communicate with the depositing device. The control unit may comprise a sub-unit internal to the depositing device and a sub-unit external to the depositing device. The control unit may further be configured to control operation of the depositing device.

According to some embodiments, the control unit may further be configured to initiate a deposition by the depositing device of the plurality of deposits of the viscous medium onto the first surface or the local surface.

For example, the control unit may send operational requests to the depositing device, instructing the depositing device to form the deposits.

According to some embodiments, the system may be in communicative contact with a storage unit. The storage unit may comprise information regarding a surface topography of at least one of a first surface of a component and a local surface of a workpiece.

Many types of devices for depositing viscous media are known in the art.

According to some embodiments, the depositing device may be selected from: a jet printing device, a dispensing device, and a laser induced forward transfer (LIFT) device.

For example, a jet printing (jetting) device may comprise an ejector for jetting droplets of the viscous medium onto the first surface or the local surface, thereby depositing the viscous medium on the surface in question. Such an ejector generally comprises a chamber for accommodating a volume of the viscous medium prior to the jetting thereof, a jetting nozzle communicating with the nozzle space, and an impacting device for impacting and jetting the viscous medium from the chamber through the nozzle in the form of droplets. Further, a feeder may be utilized to feed the medium into the nozzle space. The amount, or volume, of the deposited viscous medium at different locations on the substrate may be varied by applying several droplets on top of each other, thus forming a larger deposit, or by varying the volume of the jetted droplet by e.g. feeding a larger or smaller volume of the viscous medium into the chamber.

According to other embodiments, other depositing devices and methods are used.

The depositing device can use a contact dispensing method or a non-contact dispensing method. The depositing device can use a method where one deposit is created at a time or a method where several deposits are created at the same time or a combination of the two in a parallel event or in a series of events.

For example, the depositing device may be configured to deposit a plurality of deposits using a screen-printing (or stencil-printing) method, and then adding further viscous medium to at least one deposit. Such a depositing device may further be adapted to remove a deposit and placing a smaller deposit in its place. As an alternative, the system may comprise more than one depositing device, wherein a first depositing device forms a plurality of deposits, and a second depositing device alters the height/volume of one or more of the already formed deposits.

As an example, the depositing device may be adapted to deposit the viscous medium using needle dispensing, or any other dispensing method known in the art.

According to a third aspect of the present disclosure, a storage medium comprising instructions is provided. The instructions, when being carried out by a control unit of a system for depositing a viscous medium, will bring the control unit to obtain information regarding a surface topography of at least one of a first surface of a component and a local surface of a workpiece onto which the component is to be mounted.

The instructions will further, when being carried out by the control unit of the depositing system, bring the control unit to identify, from the obtained information, at least one portion of the first surface or the local surface at which a distance between the first surface and the local surface, upon mounting of the component on the workpiece, will be larger than an average distance between the first surface and the local surface.

Further, when being carried out by the control unit of the depositing system, the instructions will bring the depositing device to form a plurality of deposits of a viscous medium on at least one of the first surface and the local surface. At least one deposit in the identified portion has a height which is larger than an average height of the plurality of deposits.

It is noted that other embodiments using all possible combinations of features recited in the above described embodiments may be envisaged. Thus, the present disclosure also relates to all possible combinations of features mentioned herein. Specifically, features explained in more detail with reference to an aspect of the present disclosure may apply to corresponding features of another aspect of the present disclosure. For example, the system may be adapted to perform method steps described with reference to the first aspect of the disclosure. Further, the storage medium of the third aspect may comprise instructions which may bring a system of the second aspect to perform method steps of the first aspect of the disclosure.

### Brief description of drawings

Exemplifying embodiments will now be described in more detail, with reference to the following appended drawings:
Figure 1 is an illustration of a component and a workpiece, in accordance with some embodiments;
Figure 2 is a cross-section of a component and a local surface of a workpiece, in accordance with some embodiments;
Figure 3 is an illustration of a local surface of a workpiece on which a plurality of deposits has been formed, in accordance with some embodiments;
Figures 4a-c are illustrations of a component mounted on a local surface of a workpiece, in accordance with some embodiments;
Figure 5 is a further illustration of a component mounted on a local surface of a workpiece, in accordance with some embodiments;
Figure 6 is a schematic illustration of a system for depositing a viscous medium, in accordance with some embodiments.

As illustrated in the figures, the sizes of the elements and regions may be exaggerated for illustrative purposes and, thus, are provided to illustrate the general structures of the embodiments. Like reference numerals refer to like elements throughout.

### Detailed description

Exemplifying embodiments will now be described more fully hereinafter with reference to the accompanying drawings in which currently preferred embodiments are shown. The invention may, however, be embodied in many different forms and should not be construed as limited to the embodiments set forth herein; rather, these embodiments are provided for thoroughness and completeness, and fully convey the scope of the invention to the skilled person.

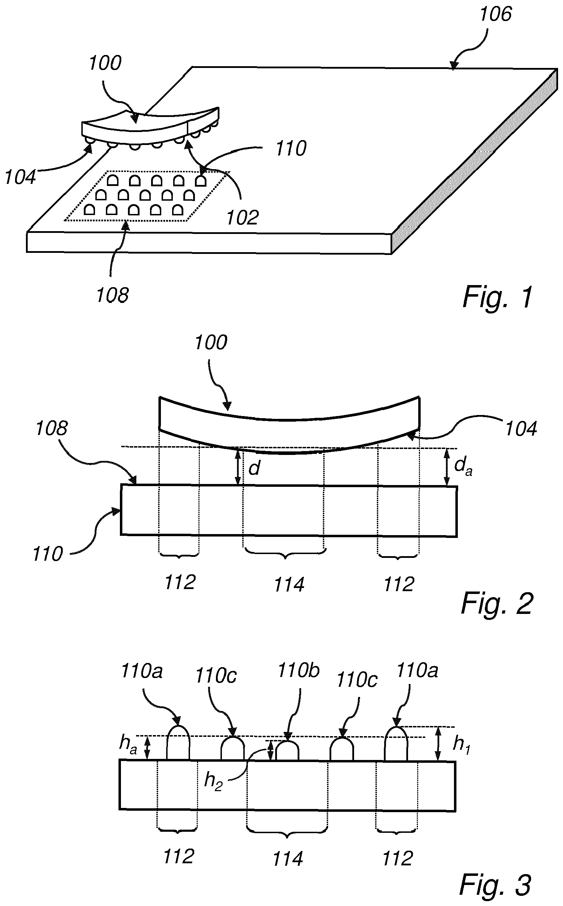

With reference to Figure 1, a component 100 and a workpiece 106, in accordance with some embodiments, will be described.

Figure 1 shows a component 100 about to be mounted on a local surface 108 of a workpiece 106. The component 100 has a first surface 102 comprising a plurality of contact pads 104. The contact pads 104 are arranged in a grid pattern on the first surface 102, although not all pads 104 are visible in Figure 1. For example, the component 100 may comprise a ball grid array (BGA).

The component 100 is warped such that the corners of the component 100 are slightly curved away from the workpiece 106. This warpage has been exaggerated for illustrative purposes.

On the workpiece 106, a plurality of deposits 110 of a viscous medium has been formed on the local surface 108. These deposits 110 are formed in positions matching the positions of the contact pads 104 of the component 100. When the component 100 is mounted on the local surface 108 of the workpiece 106, the deposits 110 should line up with the contact pads 104. After mounting, the viscous medium of the deposits 110 holds the component 100 in place. However, as the component 100 is warped, the first surface 102 is not parallel with the local surface 108. The deposits 110 depicted in Figure 1 are all of the same height, thus, since the distance between the first surface 102 of the component 100 and the local surface 108 of the workpiece 106 varies, not all deposits 110 may reach its corresponding contact pad 104. Gaps may therefore form between a deposit 110 and a contact pad 104, which may result in the component 100 not being properly held in place. In embodiments in which the component 100 is electric or optical, the deposits 110 of viscous medium may have the purpose of conveying electrical or optical signals between the component 100 and the workpiece 106. In such embodiments, a gap between the deposit 110 and the contact pad 104 or contact point may lead to functionality issues.

It will be appreciated that not all components have contact pads 104 extending from the first surface 102 as illustrated in Figure 1. Some components have other types of contact points, and other components may not have specific contact points at all.

Further, in Figure 1 and the following examples, only the component 100 is curved/warped. However, it will be appreciated that also the workpiece 106 and specifically the local surface 108 thereof, may also be warped. In some situations, both the component and the workpiece may be warped/curved, and in other situations only the component or only the workpiece may be warped.

With reference to Figure 2, identification of first portions 112 and second portions 114, in accordance with some embodiments, will be described. With reference to Figure 3, the formation of deposits 110a-c on the workpiece 106 will be described.

Figure 2 is an illustration of a component 100 and a section of a workpiece 106 comprising the local surface 108 onto which the component 100 is to be mounted. The component 100 and the workpiece 106 of Figure 2 may be equivalent to the component 100 and the workpiece 106 described above with reference to Figure 1, except in that in this example there are no contact pads 104 on the first surface 102 of the component 100.

Figure 3 is an illustration of a section of a workpiece 106 comprising the local surface 108. A plurality of deposits 110a-c of a viscous medium has been formed on the local surface 108.

In the situation illustrated in Figure 2, the first surface 102 is curved, thus information regarding the topography of the first surface may comprise information about the curvature of the first surface. The local surface 108 of the workpiece 106 is flat (not warped), thus information regarding the topography of the local surface may comprise information that the local surface is flat.

When data regarding the surfaces 102, 108 have been obtained, it is possible to predict and analyze the future distance variation between the first surface 102 and the local surface 108 when the component 100 is mounted on the workpiece 106.

The distance d between the first surface 102 and the local surface 108 varies in Figure 2. Two first portions 112 have been identified in which the distance is larger than the average distance *dₐ.* A second portion 114 has also been identified, in which the distance is smaller than the average distance *dₐ.*

In the situation illustrated in Figure 3, a plurality of deposits 110a-c have been formed on the local surface 108. The heights of all deposits 110a-c are not equal. In particular, the deposits 110a formed in the first regions 112 have a height *h*₁ which is larger than the average height *hₐ* of the deposits 110a-c. the deposit 110b which is formed in the second region 114 has a height *h*₂ which is smaller than the average height *hₐ* of the deposits 110a-c. The remaining two deposits 110c, which are formed outside of the first regions 112 and the second region 114, have heights coinciding with the average height *hₐ* of the deposits.

The analysis of the distance may be performed in different ways. As an example, the average distance *dₐ* may be calculated. After this, first portions 112 in which the distance is larger than the average distance *dₐ* may be identified, and (optionally) second portions 114 in which the distance is smaller than the average distance *dₐ* may be identified. Based on this, the step of forming the deposits may be adapted such that (at least some) deposits 110a in the first regions 112 have a height *h*₁ which is larger than an average height *hₐ* of the plurality of deposits 110a-c. Further, (optionally) at least some deposits 110c formed in second portions 114 may have a height *h*₂ which is smaller than the average height *hₐ* of the deposits 110a-c.

Often, the positions of the deposits are predetermined to match contact points of the component 100 and/or the workpiece 106. Thus, as a further example, the distance d at each predetermined position of a deposit (or at least a subset of the predetermined positions of a deposit) may be analyzed. From this analysis, regions 112, 114 in which the distance is larger or smaller than an average may be determined, and the heights of the deposits adapted accordingly. Alternatively, a compensation factor may be calculated for each analyzed position (in other words for each deposit in an analyzed position) based on the analysis of the distance at the position. Thus, each deposit in an analyzed position may receive a height adapted to the specific distance in that position. If both surfaces 102, 108 were perfectly flat, the compensation factor for each analyzed deposit would be 1, since all the deposits would have the same size, and a nominal volume or an initial estimate of volume (and height) based e.g. on the size of the contact points/pad or the distance in between the contact points may be used.

Information regarding the surface topography of the surfaces 102, 108 may not only comprise information about the current topography of the surfaces. As previously mentioned, the analyzed distance is the distance between the first surface 102 and the local surface 108 upon mounting of the component 100 on the workpiece 106. In certain embodiments, mounting the component may comprise applying energy, for example heat or radiation (such as light), directly to the deposits or to the component and the workpiece, in order to further secure the component in place. Depending on the viscous medium used, light may for example be applied to the deposits in order to cure (harden) the deposits, or heat may be applied to melt/reflow the viscous material of the deposits. The application of energy may induce a further deformation of the component 100 and/or the workpiece 106. This further deformation caused by the energy application often follows certain patterns, meaning that the further deformation may be predicted. The information regarding the surface topography of the surfaces 102, 108 may thus further comprise information regarding the predicted topography change, so that the heights of the deposits 110a-c may be adapted to compensate the predicted topography change.

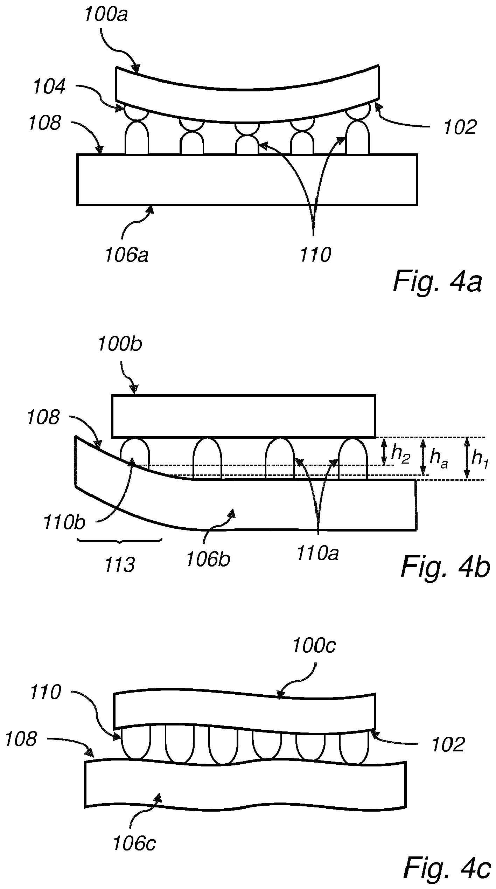

With reference to Figures 4a-c, mounting of a component 100a-c onto a local surface 108 of a workpiece 106a-c will be described.

Figures 4a-c are illustrations of a component 100a-c mounted on a local surface 108 of a workpiece 106a-c.

The component 100a and the workpiece 106a of Figure 4a may be equivalent to the components 100 and workpieces 106 described above with references to the preceding figures.

The component 100a has a plurality of contact pads 104 on its first surface 102, like in Figure 1. A plurality of deposits 110 have been formed on the local surface 108 in positions aligned with the positions of the contact pads 104. Like in Figures 2 and 3, the heights of the deposits 110 have been adapted based on the variations in distance between the first surface 102 and the local surface 108 caused by the warpage/curvature of the component 100a. Each deposit 110 thus ensures contact between the workpiece 106 and its respective contact pad 104.

Mounting of the component 100a onto the workpiece may comprise bringing the component 100a and the workpiece 106c together, aligning the first surface 102 with the local surface 108. Thus, the contact pads 104 may be aligned with the deposits 110. The viscous medium of the deposits 110 may keep the component 100 in place.

Figure 4b illustrates a component 100b mounted on a local surface 108 of a workpiece 106b. The situation shown in Figure 4b may be equivalent to the situation shown in Figure 4a, except in that the component 100b is not warped/curved while workpiece 106b is warped/curved, and that the component 100b has no contact pads.

More specifically, the workpiece 106b is curved such that an end portion 113 of the local surface 108 is curved towards the component 100b. Thus, the distance between the component 100b and the workpiece 106 b is smaller in the end portion 113, while the distance is substantially the same for the rest of the local surface 108. The deposit 110b formed in the end portion 113 has a height *h*₂ which is smaller than the average height *hₐ,* while the other deposits 110a have the same height *h*₁ which is larger than the average height *hₐ.*

Figure 4c illustrates a warped/curved component 100c mounted on a local surface 108 of a curved/warped workpiece 106c. A plurality of deposits 110 has been formed on the first surface 102 of the component 100c before mounting of the component 100c on the workpiece 106c. Each of the deposits 110 has an individual height adapted to the distance between the first surface 102 and the local surface 108 at the position at which the individual deposit is formed.

In other embodiments, deposits may be formed on both the first surface and the local surface before mounting. The deposits may be formed in corresponding positions on the surfaces, such that they line up upon mounting of the component on the workpiece. Alternatively, the deposits may be formed in complementary positions.

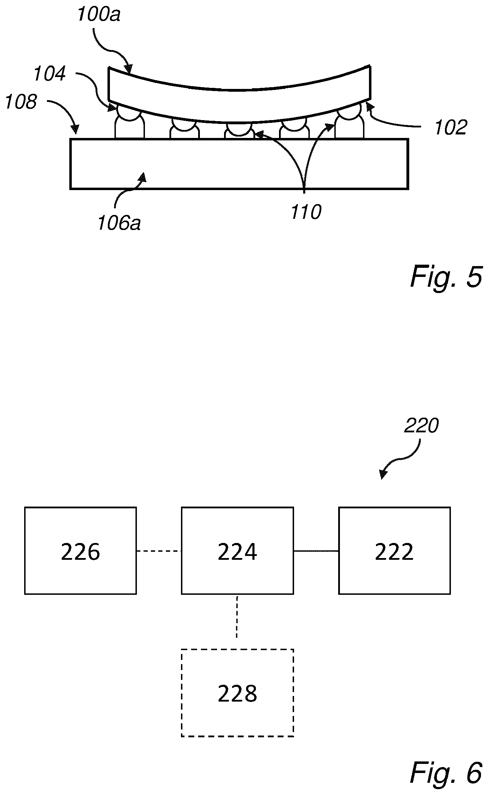

With reference to Figure 5, further steps of mounting a component 100 on a workpiece 100 will be described.

Figure 5 shows the same embodiment as depicted in Figure 4a, except in this figure, the contact pads 104 have partially sunk into the deposits 110. The viscous material of the deposits 110 may allow that the deposits 110 become deformed after initial mounting of the component 100a. For example, the deformation may take place due to gravity acting on the component 100a, or to an external force applied on the component 100a and/or the workpiece 106a during mounting of the component 100a. In some embodiments, after bringing the component 100a and the workpiece 106a together to form an assembly, heat, light or other form of energy may be applied to the assembly (comprising the component 100a and the workpiece 106a).

In some embodiments, a controlled application of heat may cause the deposits 110 to reflow, or melt. Such a decrease in viscosity(caused by the application of heat) may allow a larger contact surface between the deposits and the contact pads 104 or points on the component 100a and the workpiece 106a. This decrease in viscosity may for example cause partial sinking of the contact pads into the deposits, as shown in Figure 5. When the viscous material cools, it may harden to form more robust joints.

For example, in embodiments comprising electronic components and in which the viscous medium comprises solder paste, a controlled application of heat, light or other form of energy may cause the solder paste to reflow and form permanent solder joints

Alternatively, a controlled application of light or other form of energy may be performed to cure (harden) the viscous material of the deposits 110, thereby securing the component 100 to the workpiece 106.

With reference to Figure 5, a depositing system 220, in accordance with some embodiments, will be described.

Figure 5 is a schematic illustration of a depositing system 220 for depositing a viscous medium. The depositing system 220 comprises a depositing device 222, which is arranged for depositing a viscous medium onto a surface, such as a component 100 or a workpiece 106, as described above with reference to Figures 1-5.

The depositing system further comprises a control unit 224. The control unit 224 may be internal to the depositing device 220. In other embodiments, the control unit 224 may be an external control unit, such as a processor, computer etc., in communicative contact with the depositing device 220.

The control unit 224 is configured to obtain information about surface topographies of a first surface of a component to be mounted on the workpiece and/or a local surface of the workpiece 106 on which the component is to be mounted. This information may for example be retrieved from a storage unit 226 in communicative contact with the control unit 224. Alternatively, the depositing system may be configured to perform measurements of the first and/or local surface.

The control unit 224 is further adapted to use the obtained information to analyze how the surface topographies will affect the distance between the first surface of the component and the local surface of the workpiece 106. For example, this analysis may be performed as described with reference to Figures 2 and 3.

Specifically, the control unit 224 is adapted to identify at least one first portion (such as first portion 112 in Figures 2 and 3) of the first or local surface in which the distance between these surfaces upon mounting will be larger than an average distance between the first surface and the local surface.

The control unit 224 is further adapted to determine heights of the deposits 110 to be formed on the workpiece 106. Heights of the deposits may be adapted to the predicted distance between the first surface and the local surface upon mounting. A deposit formed in a first portion, where the distance will be larger than the average distance, may thus have a height larger than an average height of the plurality of deposits.

The control unit 224 may further be configured to initiate a deposition by the depositing device 222 of deposits of viscous medium onto the local surface of the workpiece 110. For example, the control unit may send instructions to a depositing device controller (not depicted) which may control operation of the depositing device 222. Alternatively, the control unit 224 may directly control operation of the depositing device 222.

The system 220 may comprise a second depositing device 228. The second depositing device may be configured to deposit a plurality of deposits of medium of a substantially same height viscous onto a first surface of a component or a local surface of a workpiece. The (first) depositing device 222 may then be configured to adapt a height of at least one of said plurality of deposits, e.g. by adding additional viscous medium to a deposit and/or by removing viscous medium from a deposit.

The person skilled in the art realizes that the present invention by no means is limited to the preferred embodiments described above. On the contrary, many modifications and variations are possible within the scope of the appended claims.

For example, the plurality of deposits may be formed on both the first surface of the component and on the local surface of the workpiece.

Although features and elements are described above in particular combinations, each feature or element can be used alone without the other features and elements or in various combinations with or without other features and elements.

Additionally, variations to the disclosed embodiments can be understood and effected by the skilled person in practicing the claimed invention, from a study of the drawings, the disclosure, and the appended claims. In the claims, the word "comprising" does not exclude other elements, and the indefinite article "a" or "an" does not exclude a plurality. The mere fact that certain features are recited in mutually different dependent claims does not indicate that a combination of these features cannot be used to advantage.

## Claims

1. A method for mounting a component (100) on a workpiece (106), the method comprising:
obtaining information regarding a surface topography of at least one of:
a first surface (102) of said component, and
a local surface (108) of said workpiece onto which said component is to be mounted;
identifying, from said information, at least one first portion (112) of said first surface or said local surface at which a distance (d) between said first surface and said local surface, upon mounting of said component on said workpiece, will be larger than an average distance (dₐ) between said first surface and said local surface;
forming a plurality of deposits (110) of a viscous medium on at least one of said first surface and said local surface, wherein at least one deposit (110a) formed in said at least one first portion has a height (h₁) which is larger than an average height (hₐ) of said plurality of deposits; and
bringing said first surface and said local surface together, such that said plurality of deposits of viscous medium ensures contact between said component and said workpiece.

2. The method of claim 1, wherein said obtaining information regarding a surface topography of at least one of a first surface of said component and a local surface of said workpiece comprises performing surface measurements on at least one of said first surface and said local surface.

3. The method of any of the preceding claims, wherein said obtaining information regarding a surface topography of at least one of a first surface of said component and a local surface of said workpiece comprises retrieving information of a surface topography of at least one of said first surface and said local surface from a storage unit (226).

4. The method of any of the preceding claims, further comprising:
identifying, from said information, at least one second portion (114) of said first surface or said local surface at which a distance (d) between said component and said workpiece, upon mounting of said component on said workpiece, will be smaller than the average distance (dₐ) between said first surface and said local surface; and
wherein at least one deposit formed in said at least one second portion has a height (h₂) which is smaller than the average height (hₐ) of said plurality of deposits.

5. The method of any of the preceding claims, further comprising:
for a plurality of positions, at which deposits are to be formed, analyzing a distance between said first surface and said local surface upon mounting of said component on said workpiece based on said information regarding a surface topography;
for each deposit which is to be formed in one of said plurality of positions, calculating a compensation factor based on the analysis of the distance;
wherein said forming a plurality of deposits further comprises adapting a height of each deposit being formed in one of said plurality of positions based on its compensation factor.

6. The method of any of the preceding claims, wherein said forming a plurality of deposits comprises:
forming a plurality of deposits; and
applying further viscous medium to at least one of said plurality of deposits, thereby forming at least one deposit having a height which is larger than an average height of said plurality of deposits.

7. The method of any of the preceding claims, further comprising:
after bringing said first surface and said local surface together, applying energy to the deposits, component and/or the workpiece to process said deposits; wherein
said information regarding a surface topography comprises information regarding a predicted change in topography of at least one of said first surface and said local surface resulting from the application of energy.

8. The method of any of the preceding claims, wherein said component is an electrical component.

9. The method of claim 8, wherein said viscous medium comprises an electrically conductive material.

10. A system (220) for depositing a viscous medium, said system comprising:
a depositing device (222) arranged for depositing a viscous medium onto a first surface of a component to be mounted on a workpiece or a local surface of said workpiece onto which said component is to be mounted; and
a control unit (224) adapted to:
obtain information regarding a surface topography of at least one of:
said first surface, and
said local surface of said workpiece;
identify, from said information, at least one first portion of said first surface or said local surface at which a distance between said first surface and said local surface, upon mounting of said component on said workpiece, will be larger than an average distance between said first surface and said local surface;
determine, from said identification, heights of a plurality of deposits of a viscous medium that is to be deposited on at least one of said first surface and said local surface, such that at least one deposit formed in said at least one portion has a height which is larger than an average height of said plurality of deposits.

11. The depositing system of claim 10, wherein the control unit is further configured to initiate a deposition by said depositing device of said plurality of deposits of the viscous medium onto the first surface the local surface.

12. The depositing device of any of claims 10 or 11, wherein said control unit is in communicative contact with a storage unit (226) comprising information regarding a surface topography of at least one of a first surface of an component and a local surface of a workpiece.

13. The depositing device of any of claims 10-12, wherein said depositing device is selected from a jet printing device, a dispensing device, and a LIFT device.

14. A storage medium comprising instructions which, when carried out by a control unit of a system for depositing a viscous medium, will bring a control unit of the system to:
obtain information regarding a surface topography of at least one of a first surface of a component and a local surface of a workpiece onto which said component is to be mounted; and
identify, from said information, at least one portion of said first surface or said local surface at which a distance between said component and said workpiece, upon mounting of said component on said workpiece, will be larger than an average distance between said first surface and said local surface; and
will bring a depositing device of the system to form a plurality of deposits of a viscous medium on at least one of said first surface and said local surface, wherein at least one deposit in said at least one portion has a height which is larger than an average height of said plurality of deposits.
